# EUROPEAN PATENT SPECIFICATION

(11) **EP 2 977 702 B1**
(45) Date of publication and mention of the grant of the patent: **06.03.2019**
(21) Application number: 15176907.2
(22) Date of filing: 15.07.2015
(51) Int. Cl.: F28F 3/02, F28F 3/12, F28D 1/03, H01L 23/46

(54) **HEAT TRANSFER PLATE**
WÄRMEÜBERTRAGUNGSPLATTE
PLAQUE DE TRANSFERT DE CHALEUR

(30) Priority: 22.07.2014 US 201414337444
(43) Date of publication of application: 27.01.2016
(73) Proprietor: Hamilton Sundstrand Space Systems International, Inc., Windsor Locks, CT 06096 (US)
(72) Inventor: STRANGE, Jeremy M., Windsor, CT Connecticut 06095 (US); BANACH, Thomas E., Barkhamsted, CT Connecticut 06063 (US); DIEP, Chuong H., Enfield, CT Connecticut 06082 (US)
(74) Representative: Dehns

(56) References cited:
- EP-A2- 0 111 459
- GB-A- 1 172 247
- NL-C2- 1 027 640

## Description

### BACKGROUND

### 1. Field

The present disclosure relates to heat transfer systems, more specifically to heat transferring structures and plates.

### 2. Description of Related Art

Electrical components in circuitry (e.g., aircraft or spacecraft circuits) include heat generating components and require sufficient heat transfer away from the heat generating components in order to function properly. Many mechanisms have been used to accomplish cooling, e.g., fans, heat transfer plates, and actively cooled devices such as tubes or plates including tubes therein for passing coolant adjacent a hot surface. While circuitry continues to shrink in size, developing heat transfer devices sufficient to move heat away from the components is becoming increasingly difficult.

Such conventional methods and systems have generally been considered satisfactory for their intended purpose. However, there is still a need in the art for improved heat transfer devices. Recent advancements in metal based additive manufacturing techniques allow the creation of micro-scale, geometrically complex devices not previously possible with conventional machining. The use of conductive metal and innovative geometries offers many benefits to devices cooling high heat flux energy sources. The present disclosure provides a solution for this need.

EP 0 111 459 A2 discloses a plate-type heat having the features in the preamble of claim 1 wherein a metal wire-net is disposed in the circulating fluids. NL 1 027 640 C2 discloses an element comprising a wire mesh between two spaced apart metal plates.

### SUMMARY

In at least one aspect of this disclosure, a heat transfer device includes a body defining a fluid inlet and fluid outlet, and a plurality of channels defined within the body in fluid communication between the fluid inlet and the fluid outlet, wherein the channels are interlaced and fluidly isolated from one another between the fluid inlet and the fluid outlet. The body can define a unitary matrix fluidly isolating the channels from one another between the fluid inlet and the fluid outlet.

The device can be configured to mount to an electrical component. The body can include aluminum or any other suitable material. The body can be about 0.08 inches (about 2 mm) thick or any other suitable thickness. The body can define at least one channel fluid inlet for each channel. The body can also define at least one channel fluid outlet for each channel.

The channels can be wave shaped and such that they are defined by a waveform. The wave shaped channels can be interlaced by defining the waveform of each channel off-phase from each other to avoid intersection and fluid communication of channels.

In some embodiments, the plurality of channels can be aligned in a square grid of rows and columns. In other embodiments, the plurality of channels can be defined diagonally and include at least one bend.

Each channel can be off phase by 180 degrees from each other such that the channels thermally intertwine within the body and are fluidly isolated from one another.

A method includes forming a heat transfer device by forming a body defining a fluid inlet and fluid outlet and a plurality of channels defined within the body in fluid communication between the fluid inlet and the fluid outlet, wherein the channels are interlaced and fluidly isolated from one another between the fluid inlet and the fluid outlet. This can include forming the heat transfer device by additive manufacturing.

These and other features of the systems and methods of the subject disclosure will become more readily apparent to those skilled in the art from the following detailed description taken in conjunction with the drawings.

### BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below by way of example only and with reference to certain figures, wherein:
Fig. 1 is a plan view of an exemplary embodiment of a heat transfer device in accordance with this disclosure, schematically showing fluid flow represented by flow arrows;
Fig. 2 is a schematic perspective view of a fluid volume inside a portion of the heat transfer device of Fig. 1 showing the interlaced flow channels;
Fig. 3 is a cross-sectional side elevation view of the heat transfer device of Fig. 1, showing the cross-section taken through line 3-3;
Fig. 4 is a cross-sectional plan view of a portion of the heat transfer device of Fig. 1, showing interlaced channels;
Fig. 5 is a cross-sectional plan view of a portion of the heat transfer device of Fig. 1, taken along line 5-5 as oriented in Fig. 2; and
Fig. 6 is zoomed cross-sectional view of a portion of the heat transfer device of Fig. 1.

### DETAILED DESCRIPTION

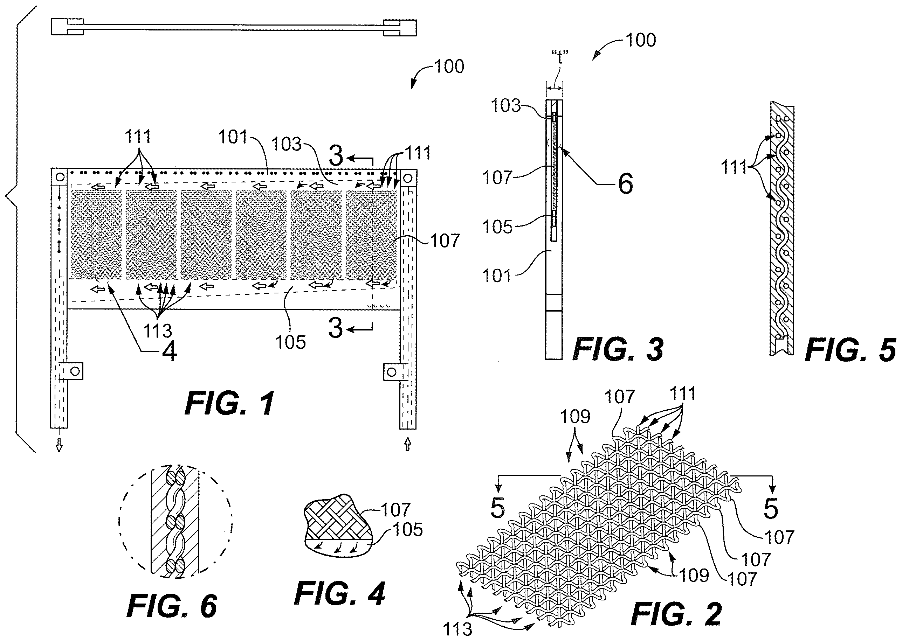

Reference will now be made to the drawings wherein like reference numerals identify similar structural features or aspects of the subject disclosure. For purposes of explanation and illustration, and not limitation, an illustrative view of an exemplary embodiment of a heat transfer device in accordance with the disclosure is shown in Fig. 1 and is designated generally by reference character 100. Other views and aspects of the exemplary heat transfer device 100 are shown in Figs. 2-6. The systems and methods described herein can be used to transfer heat from a heat source (e.g., an electrical component) to a cooling fluid passing through the heat transfer device 100, thereby cooling the heat source.

Referring generally to Fig. 1, a heat transfer device 100 includes a body 101 defining fluid inlet 103 and fluid outlet 105. The body 101, or a portion thereof, also defines a plurality of channels 107 defined within the body 101 in fluid connection between the fluid inlet 103 and the fluid outlet 105. The channels 107 are interlaced and fluidly isolated from one another between the fluid inlet 103 and the fluid outlet 105. Referring to Fig. 2, the body 101 can define a unitary matrix fluidly isolating the channels 107 from one another between the fluid inlet 103 and the fluid outlet 105. As shown in Fig. 1, the fluid inlet 103 can be a reducing shape plenum (reducing in the direction of flow), or any other suitable shape. Also as shown, the fluid outlet can include an expanding shape plenum (expanding in the direction of flow), or any other suitable shape.

The device 100 can be configured to mount to an electrical component (e.g., a microchip or other suitable device) to transfer heat therefrom and to cool the electrical component. Any other suitable heat transfer application using device 100 is contemplated herein.

Referring to Fig. 3, the body 101 can have a thickness "t" of about 0.05 inches (about 1.25 mm) to about 0.5 inches (about 12.5 mm). In some embodiments, the body 101 can be about 0.08 inches (about 2 mm) thick. The body 101 can have any other suitable thickness and/or cross-sectional design. For example, the body 101 can include a variable thickness needed to conform to specific design envelopes.

The minimum thickness is limited by the capabilities of the manufacturing process used to make the channels. The use of additive manufacturing techniques with embodiments of this disclosure allowed channels 107 with dimensions as low as about 0.02 inches (about 0.5 mm) and the overall body thickness as stated above.

The body 101 can define at least one channel fluid inlet 111 for each channel 107 such that each fluid channel connects to fluid inlet 103 at the channel fluid inlet 111. The channel fluid inlets 111 can include any suitable size and/or shape, and can differ from one another in any suitable manner. The body 101 can also define at least one channel fluid outlet 113 for each channel 107 such that each fluid channel connects to fluid outlet 105 at the channel fluid outlet 113. The channel fluid outlets 113 can include any suitable size and/or shape, and can differ from one another in any suitable manner. In this respect, flow can enter the device 100 at the inlet 103, travel into the channels 107 through channel inlets 111, pass through the channels 107, and exit the channels 107 through channel outlets 113 into outlet 105.

The channels 107 may each have a wave shape (e.g., sinusoidal as shown in Fig. 2, square, or any other suitable wave-shape) such that they are defined by a suitable waveform. The channels 107 are interlaced by defining the waveform of each channel 107 off-phase from interlaced channels to avoid intersection and to avoid fluid communication among channels 107.

In some embodiments, the plurality of channels 107 can be aligned in a square grid of rows and/or crossing columns. As shown in Fig. 2, the plurality of channels 107 can be defined diagonally relative to the direct path from inlet 103 to outlet 105. The channels 107 can include at least one bend 109 such that the channels 107 bend back at an edge of the grid and continue to interlace with each other. The bends 109 ensure that the channel inlets 111 are all aligned on one edge of the grid and the channel outlets 113 are aligned on an opposite edge of the grid. Any other suitable configuration is contemplated herein.

Each channel 107 can be off phase by 180 degrees from channels it is interlaced with, such that the channels 107 intertwine within the body 101 but remain fluidly isolated from one another. Such an arrangement allows consistent thermal transfer between the multiple channels, increasing thermal transfer of the device 100 from a heat source relative to traditional systems.

The channels 107 can have a height (amplitude of the waveform) that is less than the thickness of the body 101, but any suitable height or cross-sectional area within that thickness is contemplated herein. As stated above, the channels 107 can be about 0.02 inches thick Figs. 4-6 show cross sectional views of a portion of the flow channels 107.

The body 101 can include aluminum or any other suitable thermally conductive material. The material or combination of materials that form the body 101 can be selected on a case-by-case basis to account for thermal transfer properties to efficiently transfer heat to the fluid in the body 101.

As disclosed herein, the heat transfer device 100 efficiently transfers heat from a heat source by allowing a coolant (e.g., water or any other suitable refrigerant) to efficiently pass through the body 101 via the channels 107. The design of the channels 107 allows for a longer path within the body 101 and additional time for heat to transfer to the coolant compared to traditional configurations. Such a compact design allows for much more efficient cooling of small heat generating devices. The diagonally interlaced channel arrangement also mitigates loss of heat transfer due to poor flow distribution as every channel is in thermal communication with every other channel. This is particularly beneficial in two-phase boiling applications where large changes in density can cause flow instability.

In another aspect of this disclosure, a method includes forming a heat transfer device 100 by forming a body 101 that defines a plurality of fluidly isolated channels 107 within the body, wherein the channels 107 are interlaced and fluidly isolated from one another between the fluid inlet 103 and the fluid outlet 105. This can include forming the heat transfer device 101 by additive manufacturing. Any other suitable process for forming the device 100 can be used without departing from the scope of this disclosure.

The methods, devices, and systems of the present disclosure, as described above and shown in the drawings, provide for heat transfer devices with superior properties including increased heat transfer. While the apparatus and methods of the subject disclosure have been shown and described with reference to embodiments, those skilled in the art will readily appreciate that changes and/or modifications may be made thereto without departing from the scope of the subject disclosure as defined by the claims.

## Claims

1. A heat transfer device, comprising:
a body (101) defining a fluid inlet (103) and fluid outlet (105); and
a plurality of channels (107) defined within the body in fluid communication between the fluid inlet and the fluid outlet, **characterised in that** the channels are interlaced and fluidly isolated from one another between the fluid inlet and the fluid outlet.

2. The device of claim 1, wherein the body (101) defines a unitary matrix fluidly isolating the channels (107) from one another between the fluid inlet (103) and the fluid outlet (105).

3. The device of claim 1 or 2, wherein the device is configured to mount to an electrical component.

4. The device of any preceding claim, wherein the body (101) is about 0.08 inches thick.

5. The device of any preceding claim, wherein the body (101) defines at least one channel fluid inlet (111) for each channel (107).

6. The device of any preceding claim, wherein the body (101) defines at least one channel fluid outlet (113) for each channel (107).

7. The device of any preceding claim, wherein the channels (107) are wave shaped and are defined by a waveform.

8. The device of claim 7, wherein the wave shaped channels (107) are interlaced by defining the waveform of each channel off-phase from each other to avoid intersection and fluid communication of channels.

9. The device of any preceding claim, wherein the plurality of channels (107) are aligned in a square grid of rows and columns.

10. The device of any preceding claim, wherein the plurality of channels (107) are defined diagonally and include at least one bend (109).

11. The device of claim 10, wherein each channel (107) is off phase by 180 degrees from each other, such that the channels thermally intertwine within the body (101) and are fluidly isolated from one another.

12. The device of any preceding claim, wherein the body (101) includes aluminum.

13. A method, comprising:
forming a heat transfer device by forming a body (101) defining a fluid inlet (103) and fluid outlet (105) and a plurality of channels (107) defined within the body in fluid communication between the fluid inlet and the fluid outlet, wherein the channels are interlaced and fluidly isolated from one another between the fluid inlet and the fluid outlet.

14. The method of claim 13, wherein forming includes forming the heat transfer device by additive manufacturing.

## Patentansprüche

1. Wärmeübertragungsvorrichtung, die Folgendes umfasst:
einen Körper (101), der einen Fluideinlass (103) und einen Fluidauslass (105) definiert; und
eine Vielzahl von Kanälen (107), die innerhalb des Körpers in Fluidkommunikation zwischen dem Fluideinlass und dem Fluidauslass definiert sind, **dadurch gekennzeichnet, dass** die Kanäle verflochten und zwischen dem Fluideinlass und dem Fluidauslass fluidisch voneinander getrennt sind.

2. Vorrichtung nach Anspruch 1, wobei der Körper (101) eine Einheitsmatrix definiert, die die Kanäle (107) zwischen dem Fluideinlass (103) und dem Fluidauslass (105) fluidisch voneinander trennt.

3. Vorrichtung nach Anspruch 1 oder 2, wobei die Vorrichtung dazu konfiguriert ist, auf einer elektrischen Komponente montiert zu werden.

4. Vorrichtung nach einem der vorhergehenden Ansprüche, wobei der Körper (101) circa 0,08 Inches dick ist.

5. Vorrichtung nach einem der vorhergehenden Ansprüche, wobei der Körper (101) mindestens einen Kanalfluideinlass (111) für jeden Kanal (107) definiert.

6. Vorrichtung nach einem der vorhergehenden Ansprüche, wobei der Körper (101) mindestens einen Kanalfluidauslass (113) für jeden Kanal (107) definiert.

7. Vorrichtung nach einem der vorhergehenden Ansprüche, wobei die Kanäle (107) wellenförmig sind und durch eine Wellenform definiert sind.

8. Vorrichtung nach Anspruch 7, wobei die wellenförmigen Kanäle (107) durch das Definieren der Wellenform jedes Kanals außer Phase voneinander verflochten sind, um ein Überkreuzen und eine Fluidkommunikation von Kanälen zu vermeiden.

9. Vorrichtung nach einem der vorhergehenden Ansprüche, wobei die Vielzahl von Kanälen (107) in einem quadratischen Raster von Reihen und Spalten ausgerichtet sind.

10. Vorrichtung nach einem der vorhergehenden Ansprüche, wobei die Vielzahl von Kanälen (107) diagonal definiert sind und wenigstens eine Biegung (109) einschließen.

11. Vorrichtung nach Anspruch 10, wobei jeder Kanal (107) um 180 Grad außer Phase von jedem anderen definiert ist, sodass die Kanäle sich innerhalb des Körpers (101) thermisch verweben und fluidisch voneinander getrennt sind.

12. Vorrichtung nach einem der vorhergehenden Ansprüche, wobei der Körper (101) Aluminium einschließt.

13. Verfahren, das Folgendes umfasst:
Bilden einer Wärmeübertragungsvorrichtung durch das Bilden eines Körpers (101), der einen Fluideinlass (103) und einen Fluidauslass (105) definiert, und einer Vielzahl von Kanälen (107), die innerhalb des Körpers in Fluidkommunikation zwischen dem Fluideinlass und dem Fluidauslass definiert sind, wobei die Kanäle verflochten und zwischen dem Fluideinlass und dem Fluidauslass fluidisch voneinander getrennt sind.

14. Verfahren nach Anspruch 13, wobei das Bilden ein Bilden einer Wärmeübertragungsvorrichtung durch eine additive Herstellung einschließt.

## Revendications

1. Dispositif de transfert de chaleur, comprenant :
un corps (101) définissant une admission de fluide (103) et une évacuation de fluide (105) ; et
une pluralité de canaux (107) définis à l'intérieur du corps en communication fluidique entre l'admission de fluide et l'évacuation de fluide, **caractérisé en ce que** les canaux sont entrelacés et isolés de façon fluidique les uns des autres entre l'admission de fluide et l'évacuation de fluide.

2. Dispositif selon la revendication 1, dans lequel le corps (101) définit une matrice unitaire isolant de façon fluidique les canaux (107) les uns des autres entre l'admission de fluide (103) et l'évacuation de fluide (105).

3. Dispositif selon la revendication 1 ou 2, dans lequel le dispositif est configuré pour être monté sur un composant électrique.

4. Dispositif selon une quelconque revendication précédente, dans lequel le corps (101) présente une épaisseur d'environ 0,08 pouces.

5. Dispositif selon une quelconque revendication précédente, dans lequel le corps (101) définit au moins une admission de fluide de canal (111) pour chaque canal (107).

6. Dispositif selon une quelconque revendication précédente, dans lequel le corps (101) définit au moins une évacuation de fluide de canal (113) pour chaque canal (107).

7. Dispositif selon une quelconque revendication précédente, dans lequel les canaux (107) sont en forme d'onde et sont définis par une forme d'onde.

8. Dispositif selon la revendication 7, dans lequel les canaux en forme d'onde (107) sont entrelacés en définissant la forme d'onde de chaque canal déphasée par rapport aux autres pour éviter l'intersection et la communication fluidique de canaux.

9. Dispositif selon une quelconque revendication précédente, dans lequel la pluralité de canaux (107) est alignée dans une grille carrée de rangées et de colonnes.

10. Dispositif selon une quelconque revendication précédente, dans lequel la pluralité de canaux (107) est définie de façon diagonale et comprend au moins un coude (109).

11. Dispositif selon la revendication 10, dans lequel chaque canal (107) est déphasé de 180 degrés par rapport aux autres, de sorte que les canaux s'entremêlent thermiquement à l'intérieur du corps (101) et sont isolés de façon fluidique les uns des autres.

12. Dispositif selon une quelconque revendication précédente, dans lequel le corps (101) comprend de l'aluminium.

13. Procédé, comprenant :
la formation d'un dispositif de transfert de chaleur par la formation d'un corps (101) définissant une admission de fluide (103) et une évacuation de fluide (105) et une pluralité de canaux (107) définis à l'intérieur du corps en communication fluidique entre l'admission de fluide et l'évacuation de fluide, dans lequel les canaux sont entrelacés et isolés de façon fluidique les uns des autres entre l'admission de fluide et l'évacuation de fluide.

14. Procédé selon la revendication 13, dans lequel la formation comprend la formation du dispositif de transfert de chaleur par fabrication additive.
